Europäisches Patentamt

European Patent Office

Office européen des brevets

(11) Veröffentlichungsnummer: **0 263 270 B1**

# EUROPÄISCHE PATENTSCHRIFT

(45) Veröffentlichungstag der Patentschrift: **11.11.92**

(51) Int. Cl.5: **H01L 21/225**

(21) Anmeldenummer: **87111767.7**

(22) Anmeldetag: **13.08.87**

(54) **Verfahren zum Erzeugen eines p-dotierten Halbleitergebiets in einem n-leitenden Halbleiterkörper.**

(30) Priorität: **30.09.86 DE 3633299**

(43) Veröffentlichungstag der Anmeldung:
**13.04.88 Patentblatt 88/15**

(45) Bekanntmachung des Hinweises auf die
Patenterteilung:
**11.11.92 Patentblatt 92/46**

(84) Benannte Vertragsstaaten:
**DE FR GB SE**

(56) Entgegenhaltungen:
**FR-A- 2 301 093**
**US-A- 4 295 898**

**JOURNAL OF THE ELECTROCHEMICAL SO-
CIETY, Band 125, Nr. 6, Juni 1978, Seiten
957-962, Manchester, New-Hampshire, US; W.
ROSNOWSKI: "Aluminum diffusion into silicon in an open tube high vacuum system"**

(73) Patentinhaber: **SIEMENS AKTIENGESELL-
SCHAFT**
**Wittelsbacherplatz 2**
**W-8000 München 2(DE)**

(72) Erfinder: **Schulze, Hans-Joachim,
Dr.Dipl.-Phys.**
**Ringstrasse 16**
**W-8011 Anzing(DE)**
Erfinder: **Kuhnert, Reinhold, Dr.Dipl.-Phys.**
**Dachauer Strasse 140d**
**W-8000 München 19(DE)**

## Beschreibung

Die Erfindung bezieht sich auf ein Verfahren zum Erzeugen eines p-dotierten Halbleitergebiets in einem n-leitenden Siliziumkörper nach dem Oberbegriff des Patentanspruchs 1.

Ein Verfahren dieser Art ist aus dem J.Electrochem. Soc. Vol. 125, No. 6, Juni 1978, S. 957-962, bekannt. Hierbei werden mehrere scheibenförmige Halbleiterkörper zusammen mit einer Mehrzahl von Dotierstoffquellen, die aus Aluminiumblöcken bestehen, in ein Quarzrohr eingeführt, das an eine Vakuumpumpe angeschlossen wird, die es wenigstens bis auf $0.13 \times 10^{-3}$ Pa ($10^{-6}$ Torr) evakuiert. Danach wird ein Diffusionsofen über das evakuierte Quarzrohr geschoben und dieses während einer vorgegebenen Zeitspanne einer Diffusionstemperatur von z.B. 1150°C ausgesetzt. Nachteilig ist hierbei, daß die Innenwand des Quarzrohres zunächst passiviert werden muß, um während der Diffusion ein Absinken des Aluminium-Partialdruckes infolge von Einwirkungen des Quarzrohres auf den entstehenden Aluminiumdampf zu verhindern. Hierzu ist ein eigener Verfahrensschritt notwendig, bei dem mehrere Dotierstoffquellen in das Quarzrohr eingebracht werden und dieses nach einer vorherigen Evakuierung während einer Zeitspanne von etwa 120 min einer Temperatur von 1100°C ausgesetzt wird. Die dabei aus den Dotierstoffquellen austretenden Aluminium-Moleküle lassen an der Innenwand des Quarzrohres eine Passivierungsschicht entstehen.

Der Erfindung liegt die Aufgabe zugrunde, ein Verfahren der eingangs genannten Art anzugeben, mit dem sowohl eine hohe Randkonzentration in dem einzudiffundierenden p-Gebiet als auch die kurzen Diffusionszeiten einer Vakuumdiffusion erreichbar sind, ohne daß ein Passivierungsschritt durchgeführt werden muß. Das wird erfindungsgemäß durch eine Ausbildung gemäß dem kennzeichnenden Teil des Patentanspruchs 1 erreicht.

Der mit der Erfindung erzielbare Vorteil liegt insbesondere darin, daß einerseits kurze Diffusionszeiten ohne eine vorherige Passivierung des Hohlkörpers aus Quarz erreichbar sind und daß andererseitsdurch die Verwendung von Bor als zusätzlichem Dotierstoff die Randkonzentration der zur Bildung des p-Halbleitergebiets dienenden Dotierstofe im Halbleiterkörper ausreichend hoch ist, so daß es unproblematisch ist, das p-Halbleitergebiet mittels oberflächenseitiger Metallelektroden zu kontaktieren.

Die Patentansprüche 2 bis 5 sind auf bevorzugte Ausgestaltungen und Weiterbildungen des Verfahrens nach der Erfindung gerichtet.

Die Erfindung wird nachfolgend anhand der Zeichnung näher erläutert. Dabei zeigt:

Fig. 1 eine zur Durchführung des erfindungsgemäßen Verfahrens geeignete Diffusionsvorrichtung und

Fig. 2 einen nach dem erfindungsgemäßen Verfahren hergestellten Halbleiterkörper.

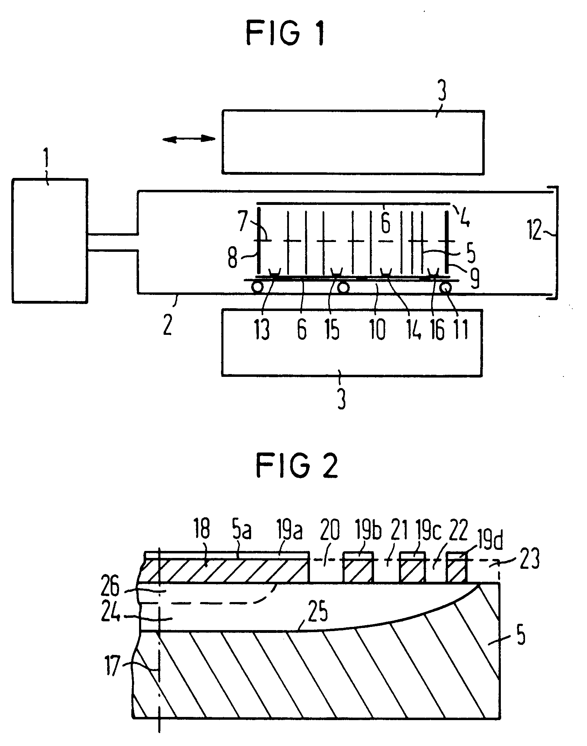

Die in Fig. 1 schematisch dargestellte Diffusionsvorrichtung umfaßt ein mit einer Vakuumpumpe 1 in Verbindung stehendes Quarzrohr 2, das von einem verschiebbaren Diffusionsofen 3 umgeben ist. Im Inneren des Quarzrohres 2 befindet sich ein Hohlkörper 4 aus Silizium, der eine Mehrzahl von scheibenförmigen, n-dotierten Halbleiterkörpern 5 aus Silizium aufnimmt, in die jeweils p-Halbleitergebiete eindiffundiert werden sollen. Der Hohlkörper 4 besteht vorzugsweise aus einem Hohlzylinder, dessen Mantel aus einer unteren und einer oberen Silizium-Halbschale 6 gebildet wird. Die Trennungsebene zwischen beiden Halbschalen ist in Fig. 1 durch eine gestrichelte Linie 7 angedeutet. An beiden Stirnseiten des Hohlzylinders 4 sind Silizium-Abschlußscheiben 8, 9 vorgesehen, die mit den Silizium-Halbschalen 6 lösbar verbunden werden. Der Hohlkörper 4 ist auf einem Träger 10 angeordnet, der im Quarzrohr 2 auf Rollen 11 längsverschiebbar gelagert ist. Nach dem Abnehmen eines endseitigen Verschlusses 12 des Quarzrohres 2 kann der Hohlkörper 4 aus dem Quarzrohr herausgezogen werden. Die obere Halbschale 6 läßt sich abnehmen, so daß die n-dotierten Halbleiterscheiben 5 in schlitzförmige Ausnehmungen der unteren Halbschale 6 einsteckbar sind.

Bei einem Ausführungsbeispiel des Verfahrens nach der Erfindung wird zum Erzeugen von p-dotierten Halbleiterbereichen in den Scheiben 5 so vorgegangen, daß aus $Al_2O_3$ gefertigte Tiegel 13, 14, welche Aluminium-Pulver oder Aluminium-Bänder enthalten, sowie weitere Tiegel 15, 16 in denen sich Bor-Pulver befindet, in die untere Halbschale 6 gestellt werden. Dabei verteilt man die Tiegel 13 bis 16 möglichst gleichmäßig auf die gesamte Länge der genannten Halbschalen. Der Hohlzylinder 4 wird dann durch Einsetzen der oberen Halbschale 6 geschlossen und in das Quarzrohr 2 eingeschoben, das durch Aufsetzen des Teiles 12 ebenfalls verschlossen wird. Nach dem Evakuieren des Quarzrohres 2 auf einen Restdruck von unter $0.13 \times 10^{-3}$ Pa ($10^{-6}$ Torr) wird der in Richtung des Doppelpfeiles verschiebbare Diffusionsofen 3 sodann in die eingezeichnete Lage gebracht, in der er den Hohlkörper 4 an beiden Enden etwa um das gleiche Maß überlappt. Anschließend werden die Halbleiterscheiben 5 während einer vorgegebenen Diffusionszeit von z.B. 4 Stunden auf eine vorgegebene Diffusionstemperatur von z.B. 1050°C erhitzt. Dabei diffundieren die Dotierstoffe Aluminium und Bor in die von eventuell vorhandenen Dotierungsmasken nicht abgedeckten Teile der Halbleiterscheibe 5 und bilden dort p-Halbleitergebiete.

Mit dem vorstehend beschriebenen Diffusionsverfahren lassen sich p-Halbleitergebiete mit ausreichend großer Randkonzentration und Eindringtiefe erzeugen, wobei eine gute Reproduzierbarkeit dieser beiden Parameter gegeben ist. Die Reproduzierbarkeit der Randkonzentration hängt vor allem damit zusammen, daß die Löslichkeitsgrenze von Bor in Silizium erreicht wird, während sich die Reproduzierbarkeit der Eindringtiefe aus der genauen Bestimmbarkeit der insgesamt eindiffundierten Aluminium-Dosis ergibt. Die geringen Diffusionszeiten der bekannten Vakuum-Aluminium-Diffusionsverfahren bleiben erhalten, ohne daß jedoch ein den Gesamtaufwand stark erhöhender Passivierungsschritt vorgenommen werden müßte. Dies wird dadurch erreicht, daß der Hohlkörper 4 aus Silizium während der Diffusionsphase ein Austreten des erzeugten Aluminium-Dampfes und somit eine Wechselwirkung desselben mit den Innenwänden des Quarzrohres 2 und die damit verbundene Reduzierung des Aluminium-Partialdruckes weitgehend verhindert.

Eine Weiterbildung der Erfindung sieht vor, daß das Einbringen der als Dotierstoffquellen dienenden Tiegel 13 bis 16 vor dem eigentlichen Diffusionsschritt entfällt und durch eine entsprechende Vorbelegung der Innenwände des Hohlkörpers 4 mit den Dotierstoffen, d.h. mit Aluminium und Bor, ersetzt wird. Die Innenwände von 4 dienen dann selbst als Dotierstoffquellen. Zu diesem Zweck werden die Dotierstoffe ohne die Halbleiterscheiben 5 im Hohlkörper 4 deponiert, worauf dieser nach dem Einführen in das Quarzrohr 2 und dem Evakuieren desselben einem Diffusionsschritt unterzogen wird, der etwa eine Diffusionszeit von 50 Stunden erfordert und bei einer Temperatur von z.B. 1050°C abläuft. Eine solche Vorbelegung, die einen sehr gleichmäßigen Diffusionsverlauf bei allen Halbleiterscheiben 5 gewährleistet und eine zu Inhomogenitäten und Defekten führende Legierungsbildung auf den Oberflächen der Siliziumscheiben 5 praktisch ausschließt, reicht aus, um mehrere erfindungsgemäße Diffusionsverfahren mit dem einmal vorbelegten Hohlkörper 4 durchzuführen. Eine Modifikation dieser Weiterbildung besteht darin, daß nur eine Vorbelegung mit Aluminium durchgeführt wird, während der zweite Dotierstoff Bor, wie ursprünglich beschrieben, mittels der Tiegel 15, 16 jeweils vor dem eigentlichen Diffusionsschritt in den Hohlkörper 5 eingebracht wird.

Das bisher beschriebene Diffusionsverfahren kann im Rahmen der Erfindung mit besonderem Vorteil dazu benutzt werden, eine Vakuumbelegung eines n-leitenden Halbleiterkörpers mit den zur Bildung eines p-Halbleitergebietes notwendigen Dotierstoffen durchzuführen. Unter einer solchen Belegung, die auch als "predeposition" bezeichnet wird, versteht man das Einbringen der Dotierstoffe in eine oberflächenseitige Zone des Halbleiterkörpers, z.B. einer Siliziumscheibe 5. Die Eindringtiefe der Zone bzw. Belegungsschicht beträgt z.B. 5 bis 10 $\mu$m. Um dies zu erreichen, wird die Diffusionszeit bei einer Belegungstemperatur von 1050°C auf etwa 2 Stunden begrenzt. Die Belegung stellt dabei eine erste Stufe eines zweistufigen Diffusionsverfahrens dar, dessen zweite Stufe dazu dient, die insoweit in die relativ flache Belegungsschicht eingebrachten Dotierstoffe tiefer in den Halbleiterkörper einzutreiben. Dies geschieht mit einem sog. Temperschritt, bei dem der Halbleiterkörper unter Entfernung der oben beschriebenen Dotierstoffquellen während einer vorgegebenen Zeitspanne von z.B. 15 bis 20 Stunden einer Temperatur von z.B. 1240°C ausgesetzt wird. Dabei diffundieren während der Belegung eingebrachte Dotierstoffatome aus der Zone weiter in den unterhalb derselben liegenden Teil des Halbleiterkörpers ein.

Insbesondere bei einer solchen zweistufigen Diffusion kommt der Vorteil der Erhöhung der Randkonzentration durch die Beigabe von Bor stark zum Tragen, da die Aluminium-Randkonzentration während des Eintreibschrittes durch Ausdiffusion des Aluminiums aus den zu dotierenden Halbleiterkörpern sehr stark absinkt.

Die mit der Belegung erreichbare geringe Eindringtiefe der entstehenden Belegungsschicht bzw. Zone bringt den wesentlichen Vorteil mit sich, daß diese Belegungsschicht relativ einfach strukturiert werden kann, um nach dem Eintreibschritt ein lateral strukturiertes p-Gebiet zu erhalten.

Als Beispiel für eine solche Strukturierung ist in Fig. 2 ein scheibenförmiger Silizium-Halbleiterkörper 5 dargestellt, der die Form einer flachen Scheibe mit kreisförmigem Querschnitt hat. Eine durch den Mittelpunkt der Querschnittsfläche gehende vertikale Achse ist mit 17 bezeichnet. Der Halbleiterkörper 5 ist dabei an seiner oberen Grenzfläche 5a mit einer etwa 5 - 10 $\mu$m dicken Zone 18 versehen, die eine die Dotierstoffe Aluminium und Bor enthaltende Belegungsschicht darstellt. Deckt man diese Belegungsschicht mit einer aus einzelnen Teilen 19a bis 19d bestehenden Maske ab und ätzt die von den Maskenteilen nicht bedeckten Teile 20 bis 23 der Belegungsschicht 18 weg, so ergibt sich die Möglichkeit, in einem folgenden Temper- oder Eintreibschritt ein p-Halbleitergebiet 24 zu erzeugen, das durch einen pn-Übergang 25 vom übrigen Teil des Halbleiterkörpers 5 getrennt ist. Dabei nähert sich der pn-Übergang 25 unterhalb der Ausnehmungen 20 bis 23 ganz allmählich der Grenzfläche 5a an, so daß auch hohe Sperrspannungen an 25 angelegt werden können. Da die durch eine Vakuumbelegung nach der Erfindung erzeugte Zone 18 sowohl hinsichtlich der Randkonzentration als auch hinsichtlich der insgesamt eingebrachten Dotierstoffmenge durch die aufgewendete Diffusionszeit und die aufgewendete Diffusionstemperatur sehr genau einstellbar ist, kann der Ätzvorgang gut auf die erhaltene Eindringtiefe der Zone 18 abgestimmt werden. Für den Fall, daß der Halbleiterkörper 5 gemäß Fig. 2 den Kollektor, das p-Halbleitergebiet 24 die Basis und ein in dieses eingebrachtes n-dotiertes Halbleitergebiet 26, das in Fig. 2 gestrichelt angedeutet ist, den Emitter eines vertikalen Transistors darstellen, ergibt sich infolge der guten Kontrollierbarkeit der unmittelbar unterhalb von 26 vorhandenen Dotierstoffkonzentration ein gut reproduzierbarer Basiswiderstand durch günstige Verteilung der Leitfähigkeit in der Tiefe der p-dotierten Schicht 24. Im einzelnen ergibt sich dort eine hohe Aluminium-Konzentration und gleichzeitig eine relativ niedrige Bor-Konzentration wegen der geringen Eindringtiefe von Bor.

Das Prinzip eines zweistufigen Diffusionsverfahrens ist an sich bekannt, z.B. aus dem Buch von R.M. Warner "Integrated Circuits", erschienen 1965 bei der McGraw-Hill Book Company, New York, vgl. insbesondere S. 294, vierter Absatz.

**Patentansprüche**

1. Verfahren zum Erzeugen eines p-dotierten Halbleitergebiets (24) in einem n-leitenden Siliziumkörper (5) mittels einer Diffusion unter Verwendung von Aluminium als Dotierstoff, bei dem der Siliziumkörper (5) neben wenigstens einer Dotierstoffquelle (13) in einen Hohlkörper (2) aus Quarz eingebracht und nach dem Evakuieren desselben während einer vorgegebenen Diffusionszeit einer vorgegebenen Diffusionstemperatur ausgesetzt wird, **dadurch gekennzeichnet,** daß als zusätzlicher Dotierstoff Bor verwendet wird und daß der Siliziumkörper (5) zusammen mit wenigstens einer Dotierstoffquelle (13 bis 16) für jeden der beiden Dotierstoffe in einen Hohlkörper (4) aus Silizium eingebracht wird, der seinerseits vor dem Evakuieren des Hohlkörpers (2) aus Quarz in diesen eingeführt wird.

2. Verfahren nach Anspruch 1, **dadurch gekennzeichnet,** daß der Hohlkörper (4) aus Silizium aus einem vorzugsweise zweiteiligen Hohlzylinder besteht, der an seinen Stirnseiten mit Silizium-Abschlußscheiben (8, 9) versehen wird.

3. Verfahren nach Anspruch 1 oder 2, **dadurch gekennzeichnet,** daß das Einbringen der Dotierstoffquellen zumindest für Aluminium in den Hohlkörper (4) aus Silizium im Wege einer Vorbelegung der Innenwände desselben mit den entsprechenden Dotierstoffen erfolgt, wobei diese zunächst im Inneren des Hohlkörpers (4) aus Silizium deponiert werden und dieser dann einem Diffusionsschritt unterzogen wird.

4. Verfahren nach einem der vorhergehenden Ansprüche, **dadurch gekennzeichnet,** daß es die erste Stufe eines zweistufigen Diffusionsverfahrens darstellt, durch die im Siliziumkörper (5) eine die Dotierstoffe enthaltende, randseitige Belegungsschicht (18) gebildet wird, und daß in der zweiten Stufe ein Eintreibschritt vorgesehen ist, bei dem der mit der Belegungsschicht (18) versehene Siliziumkörper (5) während einer vorgegebenen Zeitspanne einer vorgegebenen Temperatur ausgesetzt wird, um die Dotierstoffe weiter einzutreiben.

5. Verfahren nach Anspruch 4, **dadurch gekennzeichnet,** daß die Belegungsschicht (18) vor dem Eintreibschritt in bestimmten Teilbereichen wenigstens teilweise weggeätzt wird.

**Claims**

1. Process for producing a p-doped semiconductor region (24) in an n-type silicon body (5) by means of diffusion using aluminium as dopant, in which the silicon body (5), in addition to at least one dopant source (13), is introduced into a quartz hollow body (2) and, after the latter has been evacuated, is exposed to a specified diffusion temperature for a specified diffusion time, characterised in that boron is used as an additional dopant and in that the silicon body (5), together with at least one dopant source (13 to 16) for each of the two dopants, is introduced into a silicon hollow body (4) which is in turn introduced into the quartz hollow body (2) before the latter is evacuated.

2. Process according to Claim 1, characterised in that the silicon hollow body (4) consists of a preferably two-part hollow cylinder which is provided with silicon closing discs (8, 9) at its end faces.

3. Process according to Claim 1 or 2, characterised in that the dopant sources, at least for aluminium, are introduced into the silicon hollow body (4) by way of precoating the inside walls of the latter with the appropriate dopants, said dopants first being deposited in the interior of the silicon hollow body (4) and the latter then being subjected to a diffusion step.

4. Process according to one of the preceding claims, characterised in that it is the first stage of a two-stage diffusion process, as a result of which stage an edge side coating layer (18) containing the dopants is formed in the silicon body (5), and in that, in the second stage, a drive-in step is provided in which the silicon body (5), provided with the coating layer (18), is exposed to a specified temperature for a specified period of time in order to drive the dopants in further.

5. Process according to Claim 4, characterised in that the coating layer (18) is at least partly etched away in certain subregions before the drive-in step.

**Revendications**

1. Procédé pour produire une zone semiconductrice (24) dopée du type p dans un corps en silicium (5) conducteur du type n à l'aide d'une diffusion moyennant l'utilisation d'aluminium comme substance dopante, et selon lequel on introduit le corps en silicium (5) à côté d'au moins une source de substance dopante (13) dans un corps creux (2) en quarts et, après établissement d'un vide dans ce corps, on le soumet à une température prédéterminée de diffusion pendant une durée de diffusion prédéterminée, caractérisé par le fait qu'on utilise du bore comme substance dopante supplémentaire et qu'on introduit le corps en silicium (5) ainsi qu'au moins une source de substance dopante (13 à 16) pour chacune des deux substances dopantes, dans un corps creux (4) en silicium, que l'on introduit à son tour dans le corps creux (2) en quarts, après y avoir établi le vide.

2. Procédé suivant la revendication 1, caractérisé par le fait que le corps creux (4) est en silicium et est constitué par un cylindre creux formé de préférence de deux éléments et comportant des disques de fermeture en silicium (8,9) au niveau de ses faces frontales.

3. Procédé suivant la revendication 1 ou 2, caractérisé par le fait que l'introduction des sources de substances dopantes au moins pour l'aluminium dans le corps creux (4) en silicium est réalisée au cours d'un recouvrement préalable des parois intérieures de ce corps avec les substances dopantes correspondantes, auquel cas on dépose ces substances tout d'abord à l'intérieur du corps creux (4) en silicium et on les soumet ensuite à une étape de diffusion.

4. Procédé suivant l'une des revendications précédentes, caractérisé par le fait qu'il représente la première étape d'un procédé de diffusion en deux étapes, à l'aide duquel on forme dans le corps en silicium (5) une couche de revêtement marginale (18), qui contient les substances dopantes, et que lors de la seconde étape, il est prévu une étape de pénétration lors de laquelle on soumet le corps en silicium (5) pourvu de la couche de revêtement (18) à une température prédéterminée pendant un intervalle de temps prédéterminé de manière à faire pénétrer de façon plus conséquente les substances dopantes.

5. Procédé suivant la revendication 4, caractérisé par le fait qu'on élimine au moins partiellement, par corrosion, la couche de revêtement (18) avant l'étape de pénétration, dans des zones partielles déterminées.

# FIG 1

# FIG 2